# EUROPEAN PATENT APPLICATION

(11) **EP 4 646 045 A1**
(43) Date of publication of application: **05.11.2025**
(21) Application number: 24752662.7
(22) Date of filing: 15.01.2024
(51) Int. Cl.: H05K 7/20

(54) **HEAT DISSIPATION ASSEMBLY AND ELECTRONIC DEVICE**

(30) Priority: 10.02.2023 CN 202310139566
(71) Applicant: ZTE CORPORATION, Shenzhen, Guangdong 518057 (CN)
(72) Inventor: LIU, Jin, Shenzhen, Guangdong 518057 (CN); YE, Zuliang, Shenzhen, Guangdong 518057 (CN); LAN, Daiyan, Shenzhen, Guangdong 518057 (CN); ZHANG, Xianming, Shenzhen, Guangdong 518057 (CN)
(74) Representative: Deambrogi, Edgardo
(86) International application number: PCT/CN2024/072378
(87) International publication number: WO 2024/164804

(57) **Abstract**

Embodiments of the present invention provide a heat dissipation assembly and an electronic device. The heat dissipation assembly comprises: an evaporator and a condenser, wherein the evaporator comprises a first channel, and the condenser comprises a plurality of condenser fins, a plurality of vapor pipes and a plurality of liquid pipes; wherein each of the condenser fins comprises a second channel, the first channel is in communication with each of second channels through one of the vapor pipes and one of the liquid pipes, and the first channel and the second channel are both formed by a plurality of mutually communicated channels; and a liquid working medium sealed in the first channel of the evaporator evaporates into a vaporized working medium under the heat of a heat source, the vaporized working medium respectively enters the second channels of the corresponding condenser fins through the plurality of vapor pipes and condenses into the liquid working medium, and the liquid working medium flows back to the first channel of the evaporator through the plurality of liquid pipes. Embodiments of the present invention can solve the problems of complicated welding and low reliability due to the fact that a heat dissipation assembly needs to be provided with a large number of support pillars in the related art, and a large number of support pillars are omitted, the processing cost is reduced, and the reliability of the product is improved.

## Description

### Cross-Reference to Related Application

The present invention is based on Chinese Patent Application No. CN 2023101395661 filed on February 10, 2023 and entitled "Heat Dissipation Assembly and Electronic Device", and claims priority to the patent application, the invention of which is incorporated herein by reference in its entirety.

### Technical Field

The present invention relates to the field of heat dissipation, and in particular to a heat dissipation assembly and an electronic device.

### Background

With the rapid development of information technologies, the chip integration degree becomes higher and higher, and the power becomes larger and larger. In order to prevent chip failure, a heat dissipation apparatus is usually mounted to dissipate heat. In the related art, the following two methods are usually used to perform heat dissipation: 1. Active heat dissipation is performed by providing a fan; however, the space inside many systems or apparatuses is narrow and is not suitable for providing a fan, and the existence of forced convection power elements such as the fan may cause problems such as noise, safety, reliability, and lifetime. 2. Heat sink fins are added to perform natural convection heat dissipation, but the heat sink fins may be affected by the heat conductivity coefficient of the material itself, thereby affecting the heat dissipation effect.

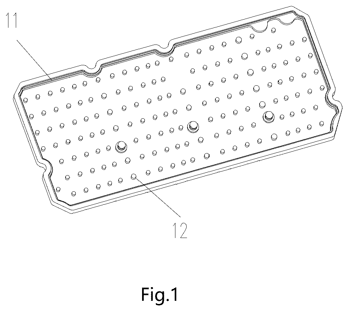

At present, the 3D Vapor Chamber (VC) heat dissipation technology is a hotspot for solving the described heat dissipation problems. Fig. 1 is a schematic diagram of a 3D VC heat sink substrate in the related art. As shown in Fig. 1, the 3D VC heat sink is generally provided with a substrate 11, and the substrate 11 is provided with a plurality of support pillars 12. An array of heat sink fins is generally provided on the upper side of the substrate, and the fins need to be closely attached to a cover plate of the substrate, and the fins need to be connected to and welded with the substrate at multiple places, thus a large number of support pillars need to be arranged on a 3D VC heat dissipation housing substrate in order to ensure the strength and the pressure resistance. However, the arrangement of the large number of support pillars makes the current 3D VC manufacturing process complex, the welding complicated, and the reliability low due to numerous welding spots.

In conclusion, there is no good solution to the problems of complicated welding and low reliability due to the fact that a heat dissipation assembly needs to be provided with a large number of support pillars in the related art.

### Summary

Embodiments of the present invention provide a heat dissipation assembly and an electronic device, so as to at least solve the problems of complicated welding and low reliability due to the fact that a heat dissipation assembly needs to be provided with a large number of support pillars in the related art.

According to some embodiments of the present invention, a heat dissipation assembly is provided, and the heat dissipation assembly comprises:
an evaporator and a condenser, wherein the evaporator comprises a first channel, and the condenser comprises a plurality of condenser fins, a plurality of vapor pipes and a plurality of liquid pipes; wherein each of the condenser fins comprises a second channel, the first channel is in communication with each of second channels through one of the vapor pipes and one of the liquid pipes, and the first channel and the second channel are both formed by a plurality of mutually communicated channels; and
a liquid working medium sealed in the first channel of the evaporator evaporates into a vaporized working medium under the heat of a heat source, the vaporized working medium respectively enters the second channels of the corresponding condenser fins through the plurality of vapor pipes and condenses into the liquid working medium, and the liquid working medium flows back to the first channel of the evaporator through the plurality of liquid pipes.

According to some other embodiments of the present invention, an electronic device is also provided, and the electronic device comprises: a heat source device and the heat dissipation assembly according to any one of the described embodiments, wherein the heat source device is disposed on the side of an evaporator away from a condenser.

### Brief Description of the Drawings

Fig. 1 is a schematic diagram of a 3D VC heat sink substrate in the related art;
Fig. 2 is a structural diagram of a heat dissipation assembly according to embodiments of the present invention;
Fig. 3 is a schematic partial cross-sectional diagram of an evaporator according to embodiments of the present invention;
Fig. 4 is a schematic partial cross-sectional diagram of a condenser fin according to embodiments of the present invention;
Fig. 5 is a schematic structural diagram of an evaporator according to embodiments of the present invention;
Fig. 6 is a schematic diagram of an arc-shaped branched channel of an evaporator according to embodiments of the present invention; and
Fig. 7 is a schematic partial cross-sectional diagram of an evaporator according to some other embodiments of the present invention.

### Detailed Description of the Embodiments

Hereinafter, embodiments of the present invention are described in detail with reference to the accompanying drawings and in conjunction with the embodiments.

It is to be noted that the terms "first", "second", etc. in the description, claims and drawings of the present invention are used to distinguish similar objects, and are not necessarily used to describe a specific sequence or a precedence order.

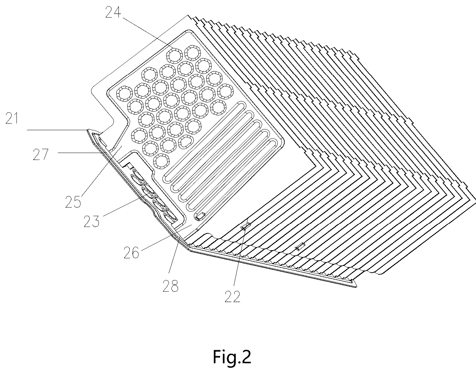

According to some embodiments of the present invention, a heat dissipation assembly is provided. Fig. 2 is a structural diagram of a heat dissipation assembly according to embodiments of the present invention. As shown in Fig. 2, the heat dissipation assembly comprises the following structures:
an evaporator 21 and a condenser 22.

In the present embodiment, the evaporator 21 comprises a first channel 23, and the condenser 22 comprises a plurality of condenser fins, a plurality of vapor pipes 25 and a plurality of liquid pipes 26; wherein each of the condenser fins comprises a second channel 24, the first channel 23 is in communication with each of second channels 24 through one of the vapor pipes 25 and one of the liquid pipes 26, and the first channel 23 and the second channel 24 are both formed by a plurality of mutually communicated channels.

In the present embodiment, the evaporator 21 is configured to evaporate a liquid working medium sealed in the first channel 23 of the evaporator to obtain a vaporized working medium, wherein the vaporized working medium enters the second channels 24 of the condenser through the vapor pipes 25.

In the present embodiment, the condenser 22 is configured to condense the vaporized working medium to obtain the liquid working medium, wherein the liquid working medium enters the first channel 23 of the evaporator through the liquid pipes 26.

In the present embodiment, the vaporized working medium and the liquid working medium are two forms of the same working medium subjected to phase change.

Specifically, the phase-change heat dissipation assembly implements heat dissipation under the effect of natural convection by using the phase-change principle of the working medium, which effectively takes away heat of an external heat source under the phase-change effect of the working medium. The heat dissipation assembly may be mounted on the external heat source, and heat enters the evaporator 21 through a base, such that a heat dissipation working medium in the evaporator 21 evaporates from a liquid state to a vapor state, and the vaporized working medium enters the vapor pipes 25 and transfers heat to the condenser 22, thereby taking heat away under the action of natural convection; then the vaporized working medium is cooled to the liquid state, and flows back to a plurality of channels of the evaporator 21 along the liquid pipes 26 under the action of gravity, and the cycle repeats in this way.

In the present embodiment, the first pipe of the evaporator and the second pipes of the condenser fins are in communication with each other through the vapor pipes 25 and the liquid pipes 26, which can simplify the welding fixture and reduce welding spots. Furthermore, the vapor pipes 25 and the liquid pipes 26 can also be used as a part of the condenser fins for integrated processing, thereby reducing the welding procedure and improving the reliability of the heat dissipation assembly.

In the present embodiment, the evaporator 21 can further specifically comprise: a liquid return region, a phase-change heat exchange region, and a vapor escape region.

Specifically, the liquid return region comprises a plurality of liquid communication grooves, and the vapor escape region comprises a plurality of vapor communication grooves; the first channel 23 is in communication with one of the liquid pipes through one of the liquid communication grooves, and the first channel 23 is in communication with one of the vapor pipes through one of the vapor communication grooves.

In the present embodiment, the liquid working medium sealed in the first channel of the evaporator evaporates into the vaporized working medium under the heat of the heat source, the vaporized working medium respectively enters the second channels of the corresponding condenser fins through the plurality of vapor pipes and condenses into the liquid working medium, and the liquid working medium flows back to the first channel of the evaporator through the plurality of liquid pipes.

In the present embodiment, the vaporized working medium and the liquid working medium are two forms of the same working medium subjected to phase change.

Specifically, the phase-change heat dissipation assembly implements heat dissipation under the effect of natural convection by using the phase-change principle of the working medium, which effectively takes away heat of the heat source under the phase-change effect of the working medium. The heat dissipation assembly may be mounted on the heat source; after absorbing the heat of the heat source, the evaporator 21 evaporates the internal heat dissipation working medium from a liquid state to a vapor state; and the vaporized working medium enters the vapor pipes and transfers heat to the condenser, thereby taking heat away under the action of natural convection or external wind; then the vaporized working medium is cooled to the liquid state, and flows back to a plurality of channels of the evaporator along the liquid pipes under the action of gravity, and the cycle repeats in this way.

In the present embodiment, the liquid pipes can be directly inserted into the liquid communication grooves for achieving connection, thereby achieving simplified mounting steps, and further reducing the welding spots. Likewise, the vapor pipes may also be directly inserted into the vapor communication grooves.

Further, the liquid working medium is usually contained in the liquid pipes and the liquid communication grooves, and the vaporized working medium is usually contained in the vapor pipes and the vapor communication grooves; therefore, when the heat dissipation assembly is mounted, the positions of the vapor pipes and the vapor communication grooves will be higher than those of the liquid pipes and the liquid communication grooves.

In the present embodiment, the phase-change heat exchange region comprises a plurality of arc-shaped branched channels, and each of the arc-shaped branched channels comprises a left-side arc-shaped channel and a right-side arc-shaped channel.

Specifically, when the phase-change working medium in the arc-shaped branched channels is heated and ascends, a part of the working medium absorbs the heat of the heat source and then evaporates. The generated bubbles move upward along the right-side arc-shaped channels and the left-side arc-shaped channels respectively, such that the liquid level can be pushed up to a greater extent, and the disturbance of the working medium fluid can also be better strengthened, thereby improving the heat transfer capability of the phase-change heat exchange region.

In the present embodiment, the evaporator 21 can further comprise: a first plate and a second plate, wherein the first plate and the second plate are laminated together by a rolling process, and the first channel is located between the first plate and the second plate.

In the present embodiment, the evaporator 21 can further comprise: a first plate, a second plate and a solder layer, wherein the first plate and the second plate are welded and laminated together via the solder layer, and the first channel is located between the first plate and the second plate.

In the present embodiment, the evaporator 21 can further comprise: a first plate, a second plate, a first intermediate plate and a solder layer, wherein the first intermediate plate is located between the first plate and the second plate, the first plate, the second plate and the first intermediate plate are welded and laminated together via the solder layer, and the first channel is located between the first plate and the second plate.

In the present embodiment, the evaporator is made of two plates or three plates, such that one or two surfaces of the evaporator can be flattened; and then the evaporator is used as a substrate of the whole heat dissipation assembly, such that a large number of support pillars are omitted, the number of parts is greatly reduced, the processing procedure is simpler, and the upper and lower surfaces of the evaporator made of three plates can both be flattened, thereby facilitating mounting.

In the present embodiment, each of the condenser fins may further comprise: a third plate and a fourth plate, wherein the third plate and the fourth plate are laminated together by a rolling process, and one of the second channels is located between the third plate and the fourth plate.

In the present embodiment, each of the condenser fins can further comprise: a third plate, a fourth plate and a solder layer, wherein the third plate and the fourth plate are laminated together via the solder layer, and one of the second channels is located between the third plate and the fourth plate.

In the present embodiment, each of the condenser fins can further comprise: a third plate, a fourth plate, a second intermediate plate and a solder layer, wherein the second intermediate plate is located between the third plate and the fourth plate, the third plate, the fourth plate and the second intermediate plate are welded and laminated together via the solder layer, and the second channel is located between the third plate and the fourth plate.

In the present embodiment, the condenser fin is made by two plates or three plates, thus the structure is simpler, the processing procedures and production costs are reduced, and the processing costs of the heat dissipation assembly can be greatly reduced.

Further, the vapor pipe and the liquid pipe may also be used as a part of the condenser fin for integrated processing, and like the second channel, the vapor pipe and the liquid pipe are located between the third plate and the fourth plate.

In the present embodiment, the evaporator and the condenser may be composed of blow-formed plates or brazed plates. The plates have a simple structure and also a lower cost.

In the present embodiment, a bent metal sheet may also be placed in the first channel of the evaporator, wherein the metal sheet is located between the first plate and the second plate of the evaporator. Specifically, the metal sheet may be a thin aluminum sheet.

In the present embodiment, by placing a bent thin aluminum sheet in the pipe of the evaporator, large disturbance can be imposed on the working medium, thereby improving the heat dissipation performance of the heat dissipation assembly and enhancing the pressure bearing capability of the pipe.

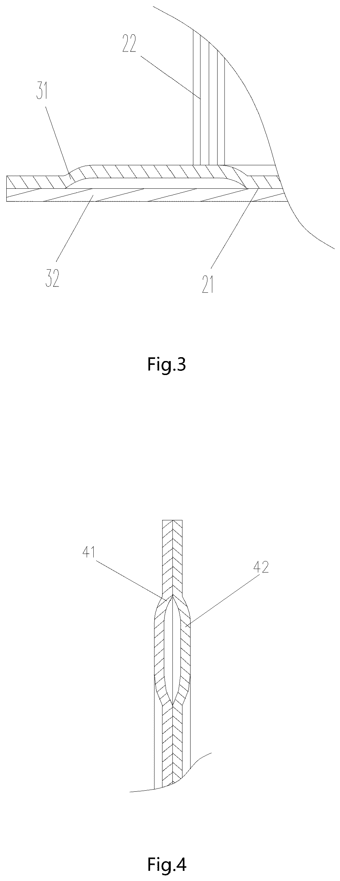

Fig. 3 is a schematic partial cross-sectional diagram of an evaporator according to embodiments of the present invention. As shown in Fig. 3, the evaporator 21 may be formed by a first plate 31 and a second plate 32, and are laminated together by a rolling process or a similar processing method.

In the present embodiment, a gap between the first plate 31 and the second plate 32 forms the first channel, and the second plate 32 can ensure that the lower surface of the evaporator is flat, such that the evaporator can be used as a substrate of the whole heat dissipation assembly and is directly mounted on the surface of the heat source.

Further, the condenser fins 22 may be mounted on the evaporator 21 in a direction perpendicular to the evaporator 21, but the present invention is not limited to this method. The specific number of condenser fins can be selected according to practical heat dissipation requirements.

Fig. 4 is a schematic partial cross-sectional diagram of a condenser fin according to embodiments of the present invention. As shown in Fig. 4, each of the condenser fins may specifically comprises: a third plate 41 and a fourth plate 42.

In the present embodiment, the third plate and the fourth plate are laminated together by means of a rolling process, a gap between the third plate and the fourth plate forms a second channel of the condenser fin, and the specific shape of the channel can be set according to heat dissipation requirements.

Specifically, the third plate and the fourth plate may be blow-formed plates or brazed plates.

In the present embodiment, the condenser fins or evaporator made of two plates have a simpler processing procedure, and reduces production costs and assembling procedures.

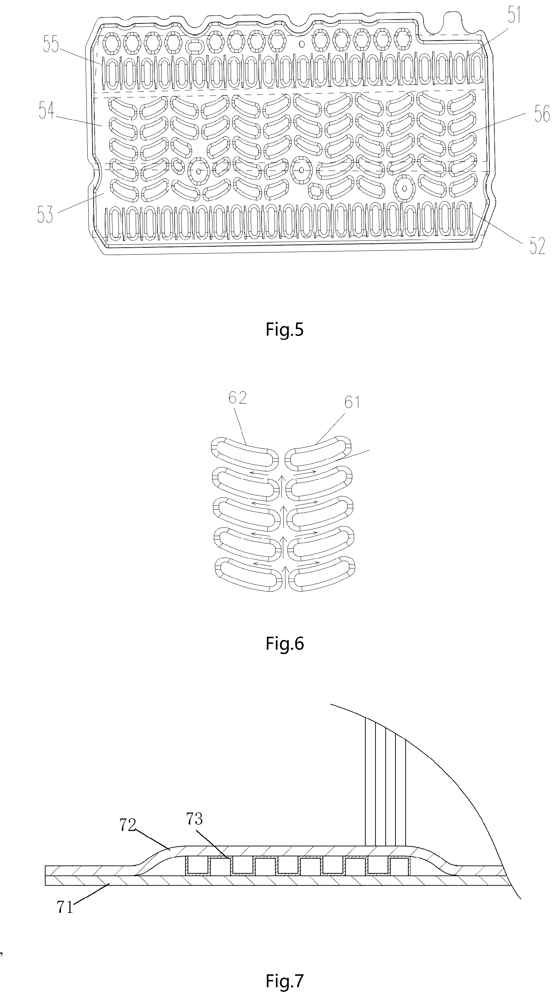

Fig. 5 is a schematic structural diagram of an evaporator according to embodiments of the present invention. As shown in Fig. 5, the evaporator may specifically comprise the following structures:
vapor communication grooves 51, liquid communication grooves 52, a liquid return region 53, a phase-change heat exchange region 54, a vapor escape region 55, and arc-shaped branched channels 56.

In the present embodiment, the vapor communication grooves 51 are located in the vapor escape region 55, the liquid communication grooves 52 are located in the liquid return region 53, and the arc-shaped branched channels 56 are located in the phase-change heat exchange region 54.

Further, the vapor communication grooves and the liquid communication grooves are in a one-to-one correspondence relationship, the specific number thereof is determined by the number of condenser fins, and each condenser fin corresponds to one vapor communication groove and one liquid communication groove.

In the present embodiment, the vapor communication grooves and the liquid communication grooves can also be set as an elongated shape, thereby increasing the number of condenser fins which can be assembled on the evaporator.

In the present embodiment, the liquid return region 53 is located at the bottom position of the evaporator, the phase-change heat exchange region 54 is located in the middle position of the evaporator, and the vapor escape region 55 is located at the top position of the evaporator.

In the present embodiment, the phase-change working medium in the liquid return region 53 is generally in a liquid state, the phase-change working medium in the vapor escape region 55 is generally in a vapor state, and the phase-change working medium in the phase-change heat exchange region 54 is vaporized from the liquid state to the vapor state by absorbing heat of the external heat source.

Fig. 6 is a schematic diagram of an arc-shaped branched channel of an evaporator according to embodiments of the present invention. As shown in Fig. 6, each arc-shaped branched channel comprises a right-side arc-shaped channel 61 and a left-side arc-shaped channel 62.

In the present embodiment, the phase-change heat exchange region of the evaporator comprises a plurality of arc-shaped branched channels, and each arc-shaped branched channel consists of a right-side arc-shaped channel 61 and a left-side arc-shaped channel 62.

In the present embodiment, when the liquid working medium is heated and ascends, a part of the liquid working medium absorbs heat of the heat source and then evaporates, and the generated bubbles move upward along the right-side arc-shaped channels 61 and the left-side arc-shaped channels 62. By the present embodiment, the liquid level can be pushed up to a greater extent, and the disturbance of the working medium fluid is better strengthened, thereby improving the heat transfer capability of the phase-change heat exchange region.

Fig. 7 is a schematic partial cross-sectional diagram of an evaporator according to some other embodiments of the present invention. As shown in Fig. 7, the evaporator can further comprise a first plate 71, a second plate 72, and a bent metal sheet 73.

In the present embodiment, the bent metal sheet 73 is located between the first plate 71 and the second plate 72.

Specifically, the bent metal sheet 73 is placed in the first channel of the evaporator, wherein the first channel is formed by a gap between the first plate 71 and the second plate 72.

Further, the bent metal sheet 73 may be a thin aluminum sheet, and may be bent in a Z-shape or S-shape.

In the present embodiment, by placing a bent thin aluminum sheet in the pipe of the evaporator, large disturbance can be imposed on the working medium, thereby improving the heat dissipation performance of the heat dissipation assembly and enhancing the pressure bearing capability of the pipe.

According to some other embodiments of the present invention, an electronic device is also provided, and the electronic device comprises: a heat source device and the heat dissipation assembly according to any one of the described embodiments, wherein the heat source device is disposed on the side of an evaporator away from a condenser.

In the present embodiment, the electronic device may be an active antenna unit (AAU for short), a radio remote unit (RRU for short), a building baseband unit (BBU for short), and the like.

Specifically, the heat source device may be a chip. By means of the embodiments of the present invention, the heat dissipation capability of the heat source device can be improved, thereby improving the processing performance of the heat source device such as a chip.

For specific examples in the present embodiment, reference can be made to the examples described in the described embodiments and exemplary embodiments, and thus they will not be repeated again in the present embodiment.

It is apparent that a person skilled in the art shall understand that all of the modules or steps in the present invention may be implemented by using a general computing apparatus, may be centralized on a single computing apparatus or may be distributed on a network composed of multiple computing apparatuses. The modules or steps may be implemented by using executable program codes of the computing apparatus, and thus, the program codes may be stored in a storage apparatus and executed by the computing apparatus, and in some cases, the shown or described steps may be executed in a sequence different from that shown herein, or the modules or steps are manufactured into integrated circuit modules, or multiple modules or steps therein are manufactured into a single integrated circuit module for implementation. Thus, the present invention is not limited to any specific hardware and software combinations.

The content above merely relates to preferred embodiments of the present invention, and is not intended to limit the present invention. For a person skilled in the art, the present invention may have various modifications and changes. Any modifications, equivalent replacements, improvements, etc. made within the principle of the present invention shall all fall within the scope of protection of the present invention.

## Claims

1. A heat dissipation assembly, the heat dissipation assembly comprising:
an evaporator and a condenser, wherein the evaporator comprises a first channel, and the condenser comprises a plurality of condenser fins, a plurality of vapor pipes and a plurality of liquid pipes; wherein each of the condenser fins comprises a second channel, the first channel is in communication with each of second channels through one of the vapor pipes and one of the liquid pipes, and the first channel and the second channel are both formed by a plurality of mutually communicated channels; and
a liquid working medium sealed in the first channel of the evaporator evaporates into a vaporized working medium under the heat of a heat source, the vaporized working medium respectively enters the second channels of the corresponding condenser fins through the plurality of vapor pipes and condenses into the liquid working medium, and the liquid working medium flows back to the first channel of the evaporator through the plurality of liquid pipes.

2. The heat dissipation assembly according to claim 1, wherein the first channel comprises:
a liquid return region, a phase-change heat exchange region and a vapor escape region, wherein the liquid return region comprises a plurality of liquid communication grooves, the vapor escape region comprises a plurality of vapor communication grooves, the plurality of liquid communication grooves are in communication with the plurality of corresponding liquid pipes, and the plurality of vapor communication grooves are in communication with the plurality of corresponding vapor pipes.

3. The heat dissipation assembly according to claim 2, wherein the phase-change heat exchange region comprises a plurality of arc-shaped branched channels, and each of the arc-shaped branched channels comprises a left-side arc-shaped channel and a right-side arc-shaped channel.

4. The heat dissipation assembly according to claim 1, wherein the evaporator comprises:
a first plate and a second plate, wherein the first plate and the second plate are laminated together by a rolling process, and the first channel is located between the first plate and the second plate.

5. The heat dissipation assembly according to claim 1, wherein the evaporator comprises:
a first plate, a second plate, and a solder layer, wherein the first plate and the second plate are welded and laminated together via the solder layer, and the first channel is located between the first plate and the second plate.

6. The heat dissipation assembly according to claim 1, wherein each of the condenser fins comprise:
a third plate and a fourth plate, wherein the third plate and the fourth plate are laminated together by a rolling process, and the second channels is located between the third plate and the fourth plate.

7. The heat dissipation assembly according to claim 1, wherein each of the condenser fins comprise:
a third plate, a fourth plate, and a solder layer, wherein the third plate and the fourth plate are laminated together via the solder layer, and the second channels is located between the third plate and the fourth plate.

8. The heat dissipation assembly according to claim 1, wherein a bent metal sheet is placed in the first channel of the evaporator, wherein the metal sheet is located between the first plate and the second plate of the evaporator.

9. The heat dissipation assembly according to claim 1, wherein
the evaporator and the condenser are composed of blow-formed plates or brazed plates.

10. An electronic device, the electronic device comprising: a heat source device and the heat dissipation assembly as claimed in any one of claims 1-9, wherein the heat source device is disposed on the side of an evaporator away from a condenser.
